# EUROPÄISCHE PATENTSCHRIFT

(11) **EP 3 338 518 B1**
(45) Veröffentlichungstag und Bekanntmachung des Hinweises auf die Patenterteilung: **03.11.2021**
(21) Anmeldenummer: 16745106.1
(22) Anmeldetag: 28.07.2016
(51) Int. Cl.: H05H 1/26, H05H 1/24

(54) **PLASMAGENERATOR UND VERFAHREN ZUR EINSTELLUNG EINES IONENVERHÄLTNISSES**
PLASMA GENERATOR AND METHOD FOR SETTING AN IONIC RATIO
GÉNÉRATEUR DE PLASMA ET PROCÉDÉ DE RÉGLAGE D'UN RAPPORT D'IONS

(30) Priorität: 18.08.2015 DE 102015113656
(43) Veröffentlichungstag der Anmeldung: 27.06.2018
(73) Patentinhaber: TDK Electronics AG, 81671 München (DE)
(72) Erfinder: WEILGUNI, Michael, 4232 Hagenberg (AT); PUFF, Markus, 8010 Graz (AT)
(74) Vertreter: Epping - Hermann - Fischer
(86) Internationale Anmeldenummer: PCT/EP2016/068094
(87) Internationale Veröffentlichungsnummer: WO 2017/029099

(56) Entgegenhaltungen:
- WO-A1-2013/043293
- DE-A1-102008 018 827
- DE-A1-102013 113 941
- JP-A- 2001 102 195
- JP-A- 2003 217 894
- US-A1- 2003 001 479
- US-A1- 2007 159 762

## Beschreibung

Die vorliegende Erfindung betrifft einen Plasmagenerator und ein Verfahren zur Einstellung des Verhältnisses von positiven zu negativen Ionen in einem von einem Plasmagenerator erzeugten Plasma. Als Verhältnis von positiven zu negativen Ionen wird hierbei das Verhältnis einer Anzahl der positiven Ionen zu der Anzahl der negativen Ionen in dem Plasma bezeichnet. Betrachtet wird dabei der Plasmastrahl, der an einem Prozessgasausgang des Plasmagenerators ausgegeben wird.

In der Druckschrift US 2003/001479 A1 wird ein negativer Ionen Generator, der eine positive Ionengeneration vermeidet, offenbart. Hier ist eine zusätzliche Stiftelektrode mit einem piezoelektrischen Transformator verbunden. Mittels Variation der Ansteuerspannung für den piezoelektrischen Transformator kann die Anzahl der negativen Ionen, die an der Stiftelektrode generiert werden, variiert werden.

Bei einem piezoelektrischen Transformator wird durch sein Funktionsprinzip bedingt mittels einer sinusförmigen Ausgangsspannung ein Plasma erzeugt. Dabei ist die Steilheit der Anstiegsflanken und der Abfallflanken der an dem piezoelektrischen Transformator erzeugten Ausgangsspannung gleich. Die Erzeugung von positiven und negativen Ionen in einem Prozessgas ist zu einem Großteil von der Steilheit dieser Flanken abhängig. Aufgrund des Funktionsprinzips der piezoelektrischen Transformatoren kann die Steilheit der Flanken nicht unterschiedlich ausgestaltet werden.

Somit ist das Verhältnis von positiven zu negativen Ionen in dem von dem piezoelektrischen Transformator erzeugten Plasma für eine vorgegebene Zusammensetzung eines Prozessgases festgelegt.

Es gibt jedoch zahlreiche Anwendungen von atmosphärischem, nicht-thermischem Plasma, bei denen die Einstellbarkeit eines bestimmten Verhältnisses von positiven zu negativen Ionen vorteilhaft ist. Hierzu gehören beispielsweise Anwendungen, bei denen atmosphärisches, nicht-thermisches Plasma zur Reinigung von Wasser verwendet wird.

DE 10 2008 018827 A1 zeigt eine Vorrichtung zur Erzeugung eines Atmosphärendruck-Plasmas mittels einer Bogenentladung, die einen piezoelektrischen Transformator und eine Gegenelektrode aufweist. US 2007/159762 A1 zeigt eine Vorrichtung zur Erzeugung einer Corona-Entladung, die eine zusätzliche Kontrollelektrode aufweist. JP 2003 217894 A und DE 10 2013 113941 A1 zeigen weitere Vorrichtungen zur Erzeugung einer Entladung.

Aufgabe der vorliegenden Erfindung ist es daher, es bei der Erzeugung von Plasma mittels eines piezoelektrischen Transformators zu ermöglichen, ein Verhältnis von positiven zu negativen Ionen in einer gewünschten Weise einzustellen.

Diese Aufgabe wird durch den Plasmagenerator gemäß dem vorliegenden Anspruch 1 gelöst. Ferner wird die Aufgabe durch das Verfahren gemäß dem zweiten unabhängigen Anspruch gelöst.

Es wird ein Plasmagenerator vorgeschlagen, der einen piezoelektrischer Transformator, der zur Ionisation eines Prozessgases geeignet ist, eine Ionenseparationselektrode, und eine Ansteuerschaltung, die dazu geeignet ist, an die Ionenseparationselektrode ein Potential anzulegen, aufweist.

Bei dem piezoelektrischen Transformator kann es sich insbesondere um einen Plasmagenerator vom Rosen-Typ handeln. Der piezoelektrische Transformator kann Plasma erzeugen, in dem er ein Prozessgas ionisiert. Bei dem Prozessgas kann es sich beispielsweise um Luft oder ein Edelgas handeln. Das Prozessgas kann durch eine an einer Ausgangsseite des piezoelektrischen Transformators erzeugte Hochspannung ionisiert werden. Dabei fungiert eine Umgebung des Transformators als Gegenelektrode.

Die Ionenseparationselektrode ist so weit von dem piezoelektrischen Transformator entfernt angeordnet, dass sie nicht als Gegenelektrode zu dem Transformator gesehen werden kann. Wird an die Ionenseparationselektrode ein Potential angelegt, so zieht diese Ionen mit einer umgekehrten Ladung an und stößt gleichgeladene Ionen ab. Ein Teil der von der Ionenseparationselektrode angezogenen Ionen wird dabei so stark abgelenkt, dass er auf die Ionenseparationselektrode auftrifft oder zumindest einen Ausgang des Plasmagenerators nicht erreicht und somit im vom Plasmagenerator ausgegebenen Plasmastrahl nicht enthalten ist. Damit kann der Anteil der Ionen dieser Ladung in dem Plasma reduziert werden.

Über die Ansteuerschaltung kann das an der Ionenseparationselektrode anliegende Potential eingestellt werden. Dadurch wird es ermöglicht, das Verhältnis von positiven und negativen Ionen stets in einer gewünschten Weise einzustellen.

Durch die Verwendung der Ionenseparationselektrode kann es somit ermöglicht werden, auch bei Plasmaerzeugung mittels eines piezoelektrischen Transformators, bei dem zunächst das Verhältnis von positiven zu negativen Ionen durch die Zusammensetzung des Prozessgases und durch die Funktionsweise des piezoelektrischen Transformators festgelegt ist, dieses Verhältnis in gewünschter Weise einzustellen. Auf diese Weise können die Vorteile von piezoelektrischen Transformatoren gegenüber anderen Methoden der Plasmageneration ausgenutzt werden und gleichzeitig ein Plasma mit einem gewünschten Verhältnis von positiven und negativen Ionen erzeugt werden. Insbesondere der hohe Wirkungsgrad des piezoelektrischen Transformators ist ein wesentlicher Vorteil der Plasmaerzeugung mittels eines piezoelektrischen Transformators.

Ferner könnte der Plasmagenerator Mittel zur Erfassung des Verhältnisses von positiven und negativen Ionen aufweisen.

Die Ansteuerschaltung könnte das an der Ionenseparationselektrode anliegende Potential abhängig von den Messwerten der Mittel zur Erfassung des Verhältnisses nachregeln.

Der Plasmagenerator kann dazu geeignet sein, von einem Prozessgas durchströmt zu werden, wobei das Prozessgas von dem piezoelektrischen Transformator ionisiert wird und anschließend durch die Ionenseparationselektrode geführt wird. In der Ionenseparationselektrode kann dabei eine Veränderung des Verhältnisses von positiven zu negativen Ionen in dem Prozessgas vorgenommen werden.

Insbesondere kann das an der Ionenseparationselektrode anliegende Potential das Verhältnis von positiven und negativen Ionen in einem von dem Plasmagenerator erzeugten Plasma festlegen.

Der Plasmagenerator kann ein Rohr aufweisen, das einen Prozessgaseingang und einen Prozessgasausgang verbindet, wobei in dem Rohr der piezoelektrische Transformator und die Ionenseparationselektrode angeordnet sind, wobei die Ionenseparationselektrode zwischen dem piezoelektrischen Transformator und dem Prozessgasausgang angeordnet ist. Das Rohr kann beispielsweise von einem Gehäuse des Plasmagenerators gebildet werden.

Die Ansteuerschaltung kann derart einstellbar sein, dass das an der Ionenseparationselektrode anliegende Potential veränderbar ist. Auf diese Weise kann jedes beliebige Verhältnis von positiven zu negativen Ionen in dem von dem Plasmagenerator erzeugten Plasma eingestellt werden.

Die Ansteuerschaltung kann einen Transformator, der dazu geeignet ist, eine Ausgangswechselspannung zu erzeugen und eine Schaltung zum Gleichrichten und Glätten der Ausgangswechselspannung aufweisen, wobei die Schaltung zum Gleichrichten und Glätten der Ausgangswechselspannung mit der Ionenseparationselektrode verbunden ist. Dementsprechend kann die Schaltung an die Ionenseparationselektrode ein Potential anlegen. Es kann sich dabei insbesondere um ein quasistatisches Potential handeln. Bei dem Transformator kann es sich insbesondere um einen zweiten piezoelektrischen Transformator handeln.

Die Ionenseparationselektrode kann gitterförmig sein oder ein Metallrohr aufweisen. Beide Formgebungen eignen sich besonders gut, um Ionen aus einem durch die Ionenseparationselektrode durchgeführten Plasmastrahl herauszufiltern. Durch die jeweilige Formgebung der Ionenseparationselektrode kann ferner auch die Form des Plasmastrahls in gewünschter Weise beeinflusst werden.

Der piezoelektrische Transformator kann zur Erzeugung von atmosphärischem, nicht-thermischen Plasma geeignet sein.

Die Ansteuerschaltung weist zumindest eine Diode auf. Die Ansteuerschaltung ist dazu ausgestaltet, ein an die Diode angelegtes Potential umzupolen. Durch die Umkehr des an der Diode anliegenden Potentials kann das Verhältnis von erzeugten positiven Ionen und erzeugten negativen Ionen umgekehrt werden.

Der piezoelektrische Transformator kann eine Endfläche aufweisen und dazu ausgestaltet sein, ein Prozessgas durch eine an seiner Endfläche erzeugte Hochspannung unmittelbar zu ionisieren. Die Endfläche kann eine Stirnseite einer Ausgangsseite des piezoelektrischen Transformators sein.

Insbesondere kann der piezoelektrische Transformator eine Eingangsseite und eine Ausgangsseite aufweisen, die sich unmittelbar an die Eingangsseite anschließt. Die Eingangsseite kann eine Vielschichtstruktur aufweisen, bei der piezoelektrische Schichten und dazwischen angeordnete erste und zweite Innenelektroden übereinandergestapelt sind. Die Ausgangsseite kann ein piezoelektrische Material und eine monolithische Struktur aufweisen.

Bei Betrieb des piezoelektrischen Transformators kann an die ersten und zweiten Innenelektroden der Eingangsseite eine Wechselspannung angelegt werden, die piezoelektrische Schwingungen in Stapelrichtung zwischen den Innenelektroden anregt. Dadurch kann sich eine Welle ausbilden, die sich in longitudinaler Richtung fortsetzt. Auf diese Weise kann an der Endfläche auf der Ausgangsseite eine Hochspannung erzeugt werden. Mittels dieser Hochspannung kann ein Prozessgas, beispielsweise Luft, ionisiert werden und auf diese Weise kann ein atmosphärisches, nicht-thermisches Plasma erzeugt werden.

Die Ionisation wird als "unmittelbar" bezeichnet, wenn das Prozessgas an der Endfläche selbst ionisiert wird. Im Gegensatz dazu steht eine mittelbare Ionisation, bei der die Hochspannung von der Endfläche abgegriffen wird und an ein weiteres Element, beispielsweise eine Elektrode, angelegt wird, um an diesem Element das Prozessgas zu ionisieren. Die unmittelbare Ionisation weist den Vorteil auf, dass hierbei Energieverluste minimiert werden können und ein kompakter Aufbau des Plasmagenerators ermöglicht wird. Beispielsweise kann der Plasmagenerator in ein tragbares Handgerät integriert sein.

Ein weiterer Aspekt der vorliegenden Erfindung betrifft ein Verfahren zur Einstellung des Verhältnisses von positiven zu negativen Ionen in einem von einem Plasmagenerator erzeugten Plasma. Bei dem Plasmagenerator kann es sich insbesondere um den oben beschriebenen Plasmagenerator handeln. Dementsprechend kann jedes strukturelle oder funktionelle Merkmal, das im Zusammenhang mit dem Plasmagenerator offenbart wurde, auch auf das Verfahren zutreffen. Jedes im Zusammenhang mit dem Verfahren offenbarte Merkmal kann in entsprechender Weise auch auf den Plasmagenerator zutreffen. Es wird ein Verfahren vorgeschlagen für einen Plasmagenerator, der einen piezoelektrischen Transformator, eine Ionenseparationselektrode und eine Ansteuerschaltung aufweist. Das Verfahren weist die folgenden Schritte auf:
- Durchströmen des Plasmagenerators mit einem Prozessgas, das von dem piezoelektrischen Transformator ionisiert wird und das anschließend durch die Ionenseparationselektrode geführt wird, und
- Einstellen des von der Ansteuerschaltung an die Ionenseparationselektrode angelegten Potentials zur Einstellung des Verhältnisses von positiven zu negativen Ionen.

Wie oben beschrieben, ermöglicht es dieses Verfahren, ein Plasma zu erzeugen, bei dem das Verhältnis von positiven zu negativen Ionen in gewünschter Weise eingestellt wird, wobei die Vorteile eines piezoelektrischen Transformators bei der Plasmaerzeugung ausgenutzt werden. Hierzu zählt insbesondere der hohe Wirkungsgrad des piezoelektrischen Transformators. Die Ansteuerschaltung kann einen Transformator aufweisen, an den eine Eingangswechselspannung angelegt wird und der eine Ausgangswechselspannung erzeugt. Bei dem Verfahren kann der Schritt des Einstellens des von der Ansteuerschaltung an die Ionenseparationselektrode angelegten Potentials dadurch durchgeführt werden, dass die an dem Transformator anliegende Eingangsspannung verändert wird.

Die Ansteuerschaltung weist zumindest eine Diode auf. Das Verfahren weist den Schritt:
- Umkehren der Diode zur Umpolung des an die Ionenseparationselektrode angelegten Potentials und zur Umkehr des Verhältnisses von positiven und negativen Ionen, auf.

Im Folgenden wird die vorliegende Erfindung anhand der Figuren genauer beschrieben.
- Figur 1: zeigt ein erstes Ausführungsbeispiel des Plasmagenerators.
- Figur 2: zeigt ein zweites Ausführungsbeispiel des Plasmagenerators.

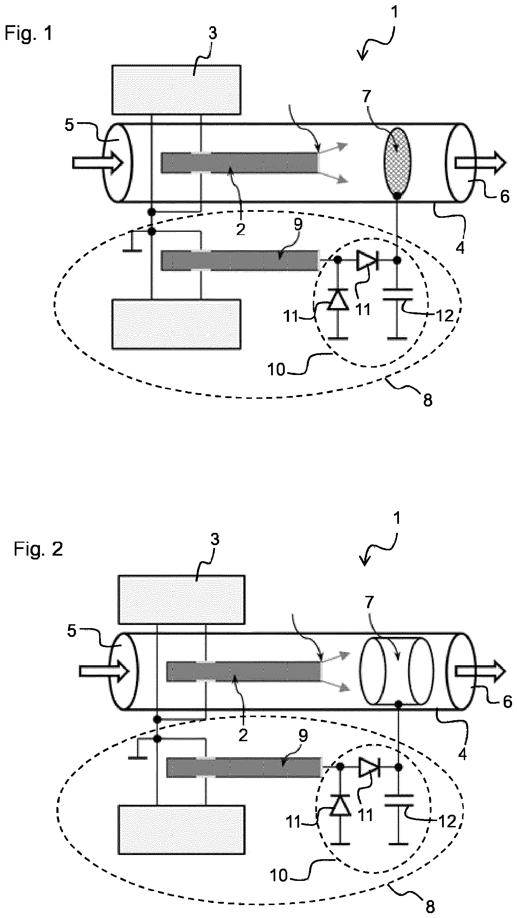

Figur 1 zeigt ein erstes Ausführungsbeispiel eines Plasmagenerators 1, bei dem es möglich ist, im erzeugten Plasma ein Verhältnis von positiven Ionen zu negativen Ionen einzustellen. Der Plasmagenerator 1 weist einen piezoelektrischen Transformator 2 auf. Der piezoelektrische Transformator 2 ist dazu geeignet, ein Prozessgas zu ionisieren und dadurch ein Plasma zu erzeugen.

Bei dem piezoelektrischen Transformator 2 handelt es sich um einen piezoelektrischen Transformator vom Rosen-Typ. Der piezoelektrische Transformator 2 ist dazu geeignet, Plasma mittels einer piezoelektrischen direkten Entladung (PDD, Piezoelectric Direct Discharge) zu erzeugen.

Der piezoelektrische Transformator 2 weist eine Eingangsseite und eine Ausgangsseite auf. Auf der Eingangsseite weist der piezoelektrische Transformator 2 eine Vielschichtstruktur auf, bei der piezoelektrische Schichten und dazwischen angeordnete erste und zweite Innenelektroden übereinandergestapelt sind. Die piezoelektrischen Schichten weisen eine Blei-Zirkonat-Titanat (PZT) Keramik auf. Auf der Eingangsseite sind die piezoelektrischen Schichten in Stapelrichtung polarisiert. Die Innenelektroden bestehen aus Kupfer.

In einer Stapelrichtung sind dabei zwischen zwei piezoelektrischen Schichten jeweils abwechselnd eine erste Innenelektrode und eine zweite Innenelektrode angeordnet. Die ersten Innenelektroden sind zu einer ersten Außenseite des piezoelektrischen Transformators 2 herausgeführt und von einer zweiten Außenseite beabstandet. Die zweiten Innenelektroden sind zu der ersten Außenseite beabstandet und zu der zweiten Außenseite herausgeführt. Ferner sind auf der ersten Außenseite und der zweiten Außenseite jeweils Außenelektroden angeordnet, die mit den zu der jeweiligen Außenseite herausgeführten Innenelektroden elektrisch kontaktiert sind.

Auf der Ausgangsseite weist der piezoelektrische Transformator 2 eine monolithische Struktur auf. Die Ausgangsseite weist das gleiche piezoelektrische Material wie die Eingangsseite auf. Die Ausgangsseite des piezoelektrischen Transformators 2 ist in longitudinaler Richtung polarisiert.

Bei Betrieb des piezoelektrischen Transformators 2 wird an die Außenelektroden auf der Eingangsseite eine Wechselspannung angelegt, die piezoelektrische Schwingungen in Stapelrichtung zwischen den Innenelektroden anregt. Dadurch kann sich eine Welle ausbilden, die sich in longitudinaler Richtung fortsetzt. Auf diese Weise kann an einer Endfläche auf der Ausgangsseite eine Hochspannung erzeugt werden. Mittels dieser Hochspannung kann ein Prozessgas, beispielsweise Luft, ionisiert werden und auf diese Weise kann ein atmosphärisches, nicht-thermisches Plasma erzeugt werden.

Bei Betrieb des piezoelektrischen Transformators 2 wirkt die Umgebung des Transformators als Gegenelektrode. Es handelt sich um eine sogenannte "Floating Electrode". Insbesondere an den Kanten und Ecken der Ausgangsseite des piezoelektrischen Transformators entsteht ein hoher Feldgradient, so dass dieser das Prozessgas ionisiert. Der hohe Feldgradient kann sich dadurch ergeben, dass an der Ausgangsseite ein Potential anliegt, das hoch ist in Bezug auf ein Referenzpotential betrachtet, bei dem es sich beispielsweise um ein Massepotential handeln kann.

Der piezoelektrische Transformator 2 ist mit einer ersten Ansteuerschaltung 3 verschaltet. Die erste Ansteuerschaltung 3 ist dazu ausgelegt, an den Außenelektroden des piezoelektrischen Transformators 2 die Eingangsspannung anzulegen. Bei der Eingangsspannung handelt es sich um eine Wechselspannung. Die Frequenz der Eingangsspannung entspricht vorzugsweise der Resonanzfrequenz des piezoelektrischen Transformators 2. Die Resonanzfrequenz wird durch die Geometrie des piezoelektrischen Transformators 2 bestimmt. Sie kann zwischen 10 und 1000 kHz betragen. Vorzugsweise kann die Resonanzfrequenz zwischen 20 und 100 kHz, beispielsweise 50 kHz, betragen.

Der Plasmagenerator 1 weist ferner ein Rohr 4 auf, das einen Prozessgaseingang 5 mit einem Prozessgasausgang 6 verbindet. Bei Betrieb des Plasmagenerators 1 kann ein Prozessgas durch das Rohr 4 strömen. Der Prozessgasstrom ist durch je einen Pfeil am Prozessgaseingang 5 und am Prozessgasausgang 6 in Figur 1 angedeutet. Bei dem Prozessgas kann es sich beispielsweise um Luft oder ein Edelgas handeln.

In dem Rohr 4 kann ein Lüfter am Prozessgaseingang 5 angeordnet sein, der Umgebungsluft ansaugt. Alternativ könnte der Prozessgaseingang 5 mit einem Druckluftreservoir verbunden werden. Am Prozessgasausgang 6 kann eine Düse angeordnet sein, die es ermöglicht, ein erzeugtes Plasma in einem Plasmastrahl von einer gewünschten Form auszugeben.

Der piezoelektrische Transformator 2 ist in dem Rohr 4 angeordnet und wird dementsprechend bei Betrieb des Plasmagenerators 1 von dem Prozessgas umströmt. An der Ausgangsseite des piezoelektrischen Transformators 2 wird das Prozessgas dabei ionisiert. Die Ionisation ist ebenfalls durch Pfeile in Figur 1 angedeutet. Durch die Zusammensetzung des Prozessgases ist das Verhältnis von positiven Ionen zu negativen Ionen in dem an der Ausgangsseite des piezoelektrischen Transformators 2 erzeugten Plasmas vorgegeben.

Im vorliegenden Plasmagenerator 1 ist es jedoch nunmehr möglich, dieses vorgegebene Verhältnis von positiven zu negativen Ionen zu verändern. Zu diesem Zweck weist der Plasmagenerator 1 eine Ionenseparationselektrode 7 auf, die in dem Rohr angeordnet ist. Die Ionenseparationselektrode 7 ist zwischen dem piezoelektrischen Transformator 2 und dem Prozessgasausgang 6 angeordnet. Dementsprechend wird das von dem piezoelektrischen Transformator 2 ionisierte Prozessgas an der Ionenseparationselektrode 7 vorbeigeführt. Die Ionenseparationselektrode 7 ist dabei soweit von dem piezoelektrischen Transformator 2 weg angeordnet, dass sie nicht als Gegenelektrode des Transformators fungiert.

Der Plasmagenerator 1 weist ferner eine zweite Ansteuerschaltung 8 auf. Die zweite Ansteuerschaltung 8 ermöglicht es, an der Ionenseparationselektrode 7 ein Potential anzulegen.

Bei dem in Figur 1 gezeigten Ausführungsbeispiel ist die zweite Ansteuerschaltung 8 dazu konfiguriert, ein positives Potential gegenüber einem Referenzpotential, beispielsweise einem Massepotential, an der Ionenseparationselektrode 7 anzulegen. Dementsprechend wird die Ionenseparationselektrode 7 die negativen Ionen des ionisierten Prozessgases anziehen und die positiven Ionen des ionisierten Prozessgases abstoßen. Ein Teil der negativen Ionen wird dabei derart von der Ionenseparationselektrode 7 angezogen, dass die negativen Ionen auf die Ionenseparationselektrode 7 auftreffen und somit den Prozessgasausgang 6 nicht erreichen. Auf diese Weise kann der Anteil der negativen Ionen in dem vom Plasmagenerator 1 ausgegebenen Plasma reduziert werden und somit das Verhältnis von positiven zu negativen Ionen verändert werden.

Der Plasmagenerator 1 verwendet dementsprechend ein Prinzip, das dem einer Vakuum-Triode entspricht, wobei hier der Gasstrom für den Ionentransport verantwortlich ist und nicht, wie im Fall der Vakuum-Triode, eine Spannung zwischen einer Anode und einer Kathode.

Es werden jedoch nicht alle negativen Ionen im Prozessgas von der Ionenseparationselektrode 7 so stark angezogen, dass sie den Prozessgasausgang 6 nicht erreichen. Vielmehr wird nur ein Teil der negativen Ionen von der Ionenseparationselektrode 7 so stark abgelenkt, dass diese Ionen den Prozessgasausgang 6 nicht erreichen. Es findet dementsprechend eine partielle Separation statt.

Wird nunmehr das an der Ionenseparationselektrode 7 anliegende Potential erhöht oder verringert, so kann dadurch der Anteil der negativen Ionen, die aus dem Prozessgasstrom ausgefiltert werden, erhöht bzw. verringert werden.

Die zweite Ansteuerschaltung 8 weist einen Transformator 9 auf. Bei dem Transformator 9 kann es sich beispielsweise um einen zweiten piezoelektrischen Transformator handeln. Die zweite Ansteuerschaltung 8 legt eine Eingangswechselspannung an eine Eingangsseite des Transformators 9 an. An einer Ausgangsseite des Transformators 9 kann eine Ausgangswechselspannung abgegriffen werden. Dabei handelt es sich um eine Hochspannung. Die zweite Ansteuerschaltung 8 ist derart ausgestaltet, dass die an dem Transformator 9 angelegte Eingangsspannung einstellbar ist. Über die Einstellung dieser Eingangsspannung kann das an der Ionenseparationselektrode 7 anliegende Potential variiert werden.

Der Ausgang des Transformators 9 ist mit einer Schaltung 10 zum Gleichrichten und Glätten der Ausgangswechselschaltung verbunden. Diese Schaltung 10 wandelt die von dem Transformator 9 erzeugte Wechselhochspannung in eine quasi statische Hochspannung um. Die Schaltung 10 zum Gleichrichten und Glätten weist zwei Dioden 11 und einen Kondensator 12 auf. Über die beiden Dioden 11 wird die von dem Transformator 9 erzeugte Hochspannung gleichgerichtet. Mittels des Kondensators 12 wird die Spannung geglättet. In dem in Figur 1 gezeigten Ausführungsbeispiel wird auf diese Weise ein gegenüber Masse positives Potential generiert, das an der Ionenseparationselektrode 7 anliegt.

Die zweite Ansteuerschaltung 8 ist ferner derart ausgestaltet, dass die Dioden 11 umgedreht werden können, sodass in diesem Fall ein negatives Potential erzeugt wird, das an der Ionenseparationselektrode 7 anliegt. In diesem Fall werden die positiven Ionen von der Ionenseparationselektrode 7 angezogen. Dementsprechend wird der Anteil der positiven Ionen im Plasma verringert und auch auf diese Weise kann das Verhältnis von positiven zu negativen Ionen in gewünschter Weise eingestellt werden.

Die zweite Ansteuerschaltung 8 kann ferner Schaltelemente aufweisen, die es ermöglichen, zwischen einer Konfiguration zum Erzeugen eines negativen Potentials und zum Erzeugen eines positiven Potentials umzuschalten. Bei diesen Schaltelementen kann es sich um zwei Hochspannungs-Reed-Relais handeln.

Bei dem in Figur 1 gezeigten Ausführungsbeispiel ist die Ionenseparationselektrode 7 gitterförmig. Sie weist dabei einen Durchmesser auf, der nur geringfügig kleiner ist als der Durchmesser des Rohres 4. Dementsprechend wird fast das gesamte ionisierte Prozessgas durch die Öffnungen in dem Gitter hindurchgeführt. Auf diese Weise kann eine effektive Separation der Ionen vorgenommen werden.

Figur 2 zeigt ein zweites Ausführungsbeispiel des Plasmagenerators 1. Das in Figur 2 gezeigte Ausführungsbeispiel unterscheidet sich von dem Ausführungsbeispiel in Figur 1 in der Ausgestaltung der Ionenseparationselektrode 7. Die Ionenseparationselektrode 7 wird hier durch ein Metallrohr gebildet. Das Metallrohr ist konzentrisch in dem Rohr 4 angeordnet.

Liegt an der Ionenseparationselektrode 7 beispielsweise ein positives Potential an, so werden in dem Metallrohr negative Ionen in radialer Richtung nach außen abgelenkt. Positive Ionen werden in der Mitte der Ionenseparationselektrode 7 fokussiert. Auf diese Weise kann es möglich sein, die Ionenverteilung in dem erzeugten Plasmastrahl derart einzustellen, dass der Anteil positiver Ionen erhöht wird, da ein gewisser Anteil der negativen Ionen so stark abgelenkt wird, dass er den Prozessgasausgang 6 nicht erreicht.

Wird das an der Ionenseparationselektrode 7 anliegende Potential umgepolt, so werden analog negative Ionen im Inneren des Plasmastrahls fokussiert und positive Ionen in radialer Richtung nach außen abgelenkt.

Über die zweite Ansteuerschaltung 8 kann das an der Ionenseparationselektrode 7 anliegende Potential in gewünschter Weise eingestellt werden und so das Verhältnis positiver zu negativer Ionen eingestellt werden.

### Bezugszeichenliste

- 1: Plasmagenerator
- 2: piezoelektrischer Transformator
- 3: erste Ansteuerschaltung
- 4: Rohr
- 5: Prozessgaseingang
- 6: Prozessgasausgang
- 7: Ionenseparationselektrode
- 8: zweite Ansteuerschaltung
- 9: piezoelektrischer Transformator
- 10: Schaltung zum Gleichrichten und Glätten
- 11: Diode
- 12: Kondensator

## Patentansprüche

1. Plasmagenerator (1) aufweisend,
einen piezoelektrischer Transformator (2), der zur Ionisation eines Prozessgases geeignet ist,
eine Ionenseparationselektrode (7), und
eine Ansteuerschaltung (8), die dazu geeignet ist, an die Ionenseparationselektrode (7) ein Potential anzulegen,
wobei die Ansteuerschaltung (8) zumindest eine Diode (11) aufweist und wobei die Ansteuerschaltung dazu ausgestaltet ist, ein an die Diode (11) angelegtes Potential umzupolen und dadurch das Verhältnis von erzeugten positiven Ionen und erzeugten negativen Ionen umzukehren.

2. Plasmagenerator (1) gemäß Anspruch 1,
wobei die Ionenseparationselektrode (7) so weit von dem piezoelektrischen Transformator (2) entfernt angeordnet ist, dass sie nicht als Gegenelektrode zu dem Transformator (2) gesehen werden kann.

3. Plasmagenerator (1) gemäß Anspruch 1,
wobei der Plasmagenerator (1) dazu geeignet ist, von einem Prozessgas durchströmt zu werden, wobei das Prozessgas von dem piezoelektrischen Transformator (2) ionisiert wird und anschließend durch die Ionenseparationselektrode (7) geführt wird.

4. Plasmagenerator (1) gemäß einem der vorherigen Ansprüche,
wobei das an der Ionenseparationselektrode (7) anliegende Potential das Verhältnis von positiven und negativen Ionen in einem von dem Plasmagenerator (1) erzeugten Plasma festlegt.

5. Plasmagenerator (1) gemäß einem der vorherigen Ansprüche,
aufweisend ein Rohr (4) mit einem Prozessgaseingang (5) und einem Prozessgasausgang (6), wobei der Prozesseingang (5) mit dem Prozessausgang (6) verbunden ist,
wobei in dem Rohr (4) der piezoelektrische Transformator (2) und die Ionenseparationselektrode (7) angeordnet sind, wobei die Ionenseparationselektrode (7) zwischen dem piezoelektrischen Transformator (2) und dem Prozessgasausgang (6) angeordnet ist.

6. Plasmagenerator (1) gemäß einem der vorherigen Ansprüche,
wobei die Ansteuerschaltung (8) derart einstellbar ist, dass das an der Ionenseparationselektrode (7) anliegende Potential veränderbar ist.

7. Plasmagenerator (1) gemäß einem der vorherigen Ansprüche,
wobei die Ansteuerschaltung (8) einen Transformator (9), der dazu geeignet ist eine Ausgangswechselspannung zu erzeugen, und eine Schaltung (10) zum Gleichrichten und Glätten der Ausgangswechselspannung aufweist, wobei die Schaltung (10) zum Gleichrichten und Glätten der Ausgangswechselspannung mit der Ionenseparationselektrode (7) verbunden ist.

8. Plasmagenerator (1) gemäß einem der vorherigen Ansprüche,
wobei die Ionenseparationselektrode (7) gitterförmig ist oder wobei die Ionenseparationselektrode (7) ein Metallrohr aufweist.

9. Plasmagenerator (1) gemäß einem der vorherigen Ansprüche,
wobei der piezoelektrische Transformator (2) zur Erzeugung von atmosphärischem, nicht-thermischen Plasma geeignet ist.

10. Plasmagenerator (1) gemäß einem der vorherigen Ansprüche,
wobei der piezoelektrische Transformator (2) eine Endfläche aufweist und dazu ausgestaltet ist, ein Prozessgas durch eine an seiner Endfläche erzeugte Hochspannung unmittelbar zu ionisieren.

11. Verfahren zur Einstellung des Verhältnisses von positiven zu negativen Ionen in einem von einem Plasmagenerator (1) erzeugten Plasma,
wobei der Plasmagenerator (1) einen piezoelektrischen Transformator (2), eine Ionenseparationselektrode (7) und eine Ansteuerschaltung (8) aufweist, wobei die Ansteuerschaltung (8) zumindest eine Diode (11) aufweist,
wobei das Verfahren die folgenden Schritte aufweist:
- Durchströmen des Plasmagenerators (1) mit einem Prozessgas, das von dem piezoelektrischen Transformator (2) ionisiert wird und das anschließend durch die Ionenseparationselektrode (7) geführt wird,
- Einstellen des von der Ansteuerschaltung (8) an die Ionenseparationselektrode (7) angelegten Potentials zur Einstellung des Verhältnisses von positiven zu negativen Ionen,
- Umkehren der Diode (11) zur Umpolung des an die Ionenseparationselektrode (7) angelegten Potentials und zur Umkehr des Verhältnisses von positiven und negativen Ionen.

12. Verfahren gemäß Anspruch 11,
wobei die Ionenseparationselektrode (7) so weit von dem piezoelektrischen Transformator (2) entfernt angeordnet ist, dass sie nicht als Gegenelektrode zu dem Transformator (2) gesehen werden kann.

13. Verfahren gemäß Anspruch 11,
wobei die Ansteuerschaltung (8) einen Transformator (9) aufweist, an den eine Eingangsspannung angelegt wird und der eine Ausgangswechselspannung erzeugt, wobei bei dem Schritt des Einstellens des von der Ansteuerschaltung (8) an die Ionenseparationselektrode (7) angelegten Potentials die an dem Transformator (9) anliegende Eingangsspannung verändert wird.

## Claims

1. Plasma generator (1) comprising
a piezoelectric transformer (2) suitable for ionizing a process gas,
an ion separation electrode (7), and
a drive circuit (8) suitable for applying a potential to the ion separation electrode (7),
wherein the drive circuit (8) comprises at least one diode (11), and wherein the drive circuit is configured to reverse the polarity of a potential applied to the diode (11) and thereby to invert the ratio of positive ions generated and negative ions generated.

2. Plasma generator (1) according to Claim 1,
wherein the ion separation electrode (7) is arranged at such a distance from the piezoelectric transformer (2) that it cannot be regarded as a counterelectrode with respect to the transformer (2).

3. Plasma generator (1) according to Claim 1,
wherein the plasma generator (1) is suitable for a process gas to flow through it, wherein the process gas is ionized by the piezoelectric transformer (2) and is subsequently guided through the ion separation electrode (7).

4. Plasma generator (1) according to any of the preceding claims,
wherein the potential present at the ion separation electrode (7) defines the ratio of positive and negative ions in a plasma generated by the plasma generator (1).

5. Plasma generator (1) according to any of the preceding claims,
comprising a tube (4) having a process gas inlet (5) and a process gas outlet (6), wherein the process inlet (5) is connected to the process outlet (6), wherein the piezoelectric transformer (2) and the ion separation electrode (7) are arranged in the tube (4), wherein the ion separation electrode (7) is arranged between the piezoelectric transformer (2) and the process gas outlet (6).

6. Plasma generator (1) according to any of the preceding claims,
wherein the drive circuit (8) is adjustable in such a way that the potential present at the ion separation electrode (7) is variable.

7. Plasma generator (1) according to any of the preceding claims,
wherein the drive circuit (8) comprises a transformer (9) suitable for generating an AC output voltage and a circuit (10) for rectifying and smoothing the AC output voltage, wherein the circuit (10) for rectifying and smoothing the AC output voltage is connected to the ion separation electrode (7) .

8. Plasma generator (1) according to any of the preceding claims,
wherein the ion separation electrode (7) is grid-shaped or wherein the ion separation electrode (7) comprises a metal tube.

9. Plasma generator (1) according to any of the preceding claims,
wherein the piezoelectric transformer (2) is suitable for generating an atmospheric, non-thermal plasma.

10. Plasma generator (1) according to any of the preceding claims,
wherein the piezoelectric transformer (2) comprises an end face and is configured to directly ionize a process gas by means of a high voltage generated at its end face.

11. Method for setting the ratio of positive to negative ions in a plasma generated by a plasma generator (1),
wherein the plasma generator (1) comprises a piezoelectric transformer (2), an ion separation electrode (7) and a drive circuit (8), wherein the drive circuit (8) comprises at least one diode (11), wherein the method comprises the following steps:
- causing a process gas to flow through the plasma generator (1), which process gas is ionized by the piezoelectric transformer (2) and is subsequently guided through the ion separation electrode (7),
- setting the potential applied to the ion separation electrode (7) by the drive circuit (8) for the purpose of setting the ratio of positive to negative ions
- inverting the diode (11) for reversing the polarity of the potential applied to the ion separation electrode (7) and for inverting the ratio of positive and negative ions.

12. Method according to Claim 11,
wherein the ion separation electrode (7) is arranged at such a distance from the piezoelectric transformer (2) that it cannot be regarded as a counterelectrode with respect to the transformer (2) .

13. Method according to Claim 11,
wherein the drive circuit (8) comprises a transformer (9), to which an input voltage is applied and which generates an AC output voltage, wherein the input voltage present at the transformer (9) is varied during the step of setting the potential applied to the ion separation electrode (7) by the drive circuit (8).

## Revendications

1. Générateur de plasma (1) comportant
un transformateur piézoélectrique (2) qui est conçu pour ioniser un gaz de traitement,
une électrode de séparation d'ions (7), et
un circuit de commande (8) qui est conçu pour appliquer un potentiel sur l'électrode de séparation d'ions (7),
le circuit de commande (8) comportant au moins une diode (11) et le circuit de commande étant conçu pour inverser un potentiel appliqué sur la diode (11) et inverser ainsi le rapport des ions positifs générés aux ions négatifs générés.

2. Générateur de plasma (1) selon la revendication 1,
l'électrode de séparation d'ions (7) étant disposée à distance du transformateur piézoélectrique (2) de façon à ce qu'elle ne puisse pas être considérée comme une contre-électrode du transformateur (2).

3. Générateur de plasma (1) selon la revendication 1,
le générateur de plasma (1) étant conçu pour laisser passer un gaz de traitement, le gaz de traitement étant ionisé par le transformateur piézoélectrique (2) puis amené à travers l'électrode de séparation d'ions (7).

4. Générateur de plasma (1) selon l'une des revendications précédentes,
le potentiel appliqué sur l'électrode de séparation d'ions (7) définissant le rapport des ions positifs aux ions négatifs dans un plasma généré par le générateur de plasma (1).

5. Générateur de plasma (1) selon l'une des revendications précédentes, comportant un tube (4) pourvu d'une entrée de gaz de traitement (5) et une sortie de gaz de traitement (6), l'entrée de traitement (5) étant reliée à la sortie de traitement (6),
le transformateur piézoélectrique (2) et l'électrode de séparation d'ions (7) étant disposés dans le tube (4), l'électrode de séparation d'ions (7) étant disposée entre le transformateur piézoélectrique (2) et la sortie de gaz de traitement (6).

6. Générateur de plasma (1) selon l'une des revendications précédentes,
le circuit de commande (8) pouvant être réglé de telle sorte que le potentiel appliqué sur l'électrode de séparation d'ions (7) puisse être modifié.

7. Générateur de plasma (1) selon l'une des revendications précédentes,
le circuit de commande (8) comportant un transformateur (9) qui est conçu pour générer une tension alternative de sortie, et un circuit (10) destiné à redresser et lisser la tension alternative de sortie, le circuit (10) destiné à redresser et lisser la tension alternative de sortie étant relié à l'électrode de séparation d'ions (7).

8. Générateur de plasma (1) selon l'une des revendications précédentes,
l'électrode de séparation d'ions (7) étant en forme de grille ou l'électrode de séparation d'ions (7) comportant un tube métallique.

9. Générateur de plasma (1) selon l'une des revendications précédentes,
le transformateur piézoélectrique (2) état conçu pour générer un plasma atmosphérique non thermique.

10. Générateur de plasma (1) selon l'une des revendications précédentes,
le transformateur piézoélectrique (2) comportant une surface d'extrémité et étant conçu pour ioniser directement un gaz de traitement au moyen d'une haute tension générée sur sa surface d'extrémité.

11. Procédé de réglage du rapport des ions positifs aux ions négatifs dans un plasma généré par un générateur de plasma (1),
le générateur de plasma (1) comportant un transformateur piézoélectrique (2), une électrode de séparation d'ions (7) et un circuit de commande (8), le circuit de commande (8) comportant au moins une diode (11),
le procédé comprenant les étapes suivantes :
- faire passer à travers le générateur de plasma (1) un gaz de traitement qui est ionisé par le transformateur piézoélectrique (2) et qui est ensuite passé à travers l'électrode de séparation d'ions (7),
- régler le potentiel appliqué sur l'électrode de séparation d'ions (7) par le circuit de commande (8) pour régler le rapport des ions positifs aux ions négatifs,
- inverser la diode (11) pour inverser la polarité du potentiel appliqué sur l'électrode de séparation d'ions (7) et pour inverser le rapport des ions positifs aux ions négatifs.

12. Procédé selon la revendication 11,
l'électrode de séparation d'ions (7) étant disposée à distance du transformateur piézoélectrique (2) de sorte qu'elle ne puisse pas être considérée comme une contre-électrode du transformateur (2).

13. Procédé selon la revendication 11,
le circuit de commande (8) comportant un transformateur (9) sur lequel une tension d'entrée est appliquée et qui génère une tension alternative de sortie, la tension d'entrée appliquée sur le transformateur (9) étant modifiée à l'étape de réglage du potentiel appliqué sur l'électrode de séparation d'ions (7) par le circuit de commande (8).
